**Europäisches Patentamt**

**European Patent Office**

**Office européen des brevets**

(19)

(11) Veröffentlichungsnummer: **0 075 175**
A2

# (12) EUROPÄISCHE PATENTANMELDUNG

(21) Anmeldenummer: **82108200.5**

(22) Anmeldetag: **06.09.82**

(51) Int. Cl.³: **F 28 C 3/00, H 05 K 7/20**

(30) Priorität: **17.09.81 DE 3137034**

(43) Veröffentlichungstag der Anmeldung: **30.03.83**
**Patentblatt 83/13**

(84) Benannte Vertragsstaaten: **AT CH DE FR GB LI NL**

(71) Anmelder: **SIEMENS AKTIENGESELLSCHAFT, Berlin und München Wittelsbacherplatz 2, D-8000 München 2 (DE)**

(72) Erfinder: **Opitz, Heinrich, Dipl.-Chem., Breslauer Strasse 1, D-8520 Erlangen (DE)**
Erfinder: **Montag, Bernhard, Nordring 22, D-8550 Forchheim (DE)**
Erfinder: **Urban, Gerd, Stettiner Strasse 22, D-8520 Erlangen (DE)**
Erfinder: **Türk, Wilfried, Dipl.-Ing., Bellinzonastrasse 16, D-8000 München 71 (DE)**

(54) **Verfahren und Vorrichtung zum Wärmetausch an festen Oberflächen.**

(57) Die Erfindung betrifft ein Verfahren und eine Vorrichtung zum Wärmetausch, insbesondere zur Kühlung an festen Oberflächen. An den festen Oberflächen wird ein örtlich gleichmäßiger, konvektiver Wärmetausch verreicht. Erfindungsgemäß wird in einer Strömungskammer (1) an einer Oberfläche einer wärmeleitenden festen Wand (9) mit Hilfe eines Leitapparates (2) einer Kreisströmung eines Fluids eine Senkenströmung überlagert unter Bildung einer Wirbelsenkenströmung. Die Wärmetauschfläche des zu kühlenden Bauteils (9) ist gleichzeitig die Grundplatte (8) einer Strömungskammer (1).

0075175

SIEMENS AKTIENGESELLSCHAFT
Berlin und München

Unser Zeichen
VPA 81 P 7 5 7 1 E

Verfahren und Vorrichtung zum Wärmetausch an festen Oberflächen

Die Erfindung betrifft ein Verfahren zum Wärmetausch an festen Oberflächen sowie eine Vorrichtung zur Durchführung des Verfahrens.

Bei Stromfluß in elektrischen Apparaten entsteht immer Verlustwärme. Infolge immer dichterer Packung von aktiven und passiven elektronischen Bauteilen ergeben sich immer höhere Verlustwärmestromdichten. Um die Lebensdauer der elektronischen Bauteile nicht zu verkürzen, muß man die Verlustwärme durch Kühlung abführen. Bisher wurde mit konvektiver Zwangsluftkühlung ausreichend gekühlt. Dies reicht in Zukunft nicht mehr aus. Da die Wärmeübergangszahl von Wasser etwa 60 bis 100 mal größer ist als Luft, ist es daher zweckmäßig, die elektrische Verlustwärme,z.B. durch Wasserkühlung, zu entfernen.

Gemäß der europäischen Patentanmeldung 0 001 153 wird jeder einzelne elektronische Baustein individuell gekühlt, indem ein gut wärmeleitender Metallkörper auf den elektronischen Baustein aufgedrückt wird. Dadurch verteilt sich die Verlustwärme auf eine große Oberfläche des Metallkörpers. Die Ableitung von diesem Metallkörper geschicht über eine dünne Heliumgasstrecke an eine Wasserkühlung. Dies erfordert relativ hohen technischen Aufwand.

Td 2 Gr / 26.8.1981

Aufgabe der Erfindung ist es, die Verlustwärmeabfuhr aus erwärmten Bauteilen, vor allem aus elektrischen Bauteilen, zu verbessern und eine lokale Überhitzung einzelner Bauteile zu vermeiden.

Diese Aufgabe wird dadurch gelöst, daß/in einer Strömungskammer an einer Oberfläche einer wärmeleitenden festen Wand mit Hilfe eines Leitapparates einer Kreisströmung eines Fluids eine Senkenströmung überlagert wird unter Bildung einer sogenannten Wirbelsenkenströmung. Als wärmetauschende Oberfläche wird bevorzugt die Rückseite eingesetzt. So kann durch die Erfindung die Verlustwärme von Bauelementen an den Rückseiten wärmeleitfähig durchkontaktierter Leiterplatten abgeführt werden und eine örtlich sehr gleichmäßige Kühlung erreicht werden unter Verwendung einer lokalen Überhitzung der einzelnen Bauteile.

Gemäß einer bevorzugten Ausführung wird das Kühlmittel tangential durch mindestens einen Leitapparat in die Strömungskammer eingeleitet. Das Kühlmittel wird aus der Strömungskammer senkrecht zur Strömungsebene im Zentrum des Wirbels durch den wärmeisolierten zentralen Auslauf abgeleitet.

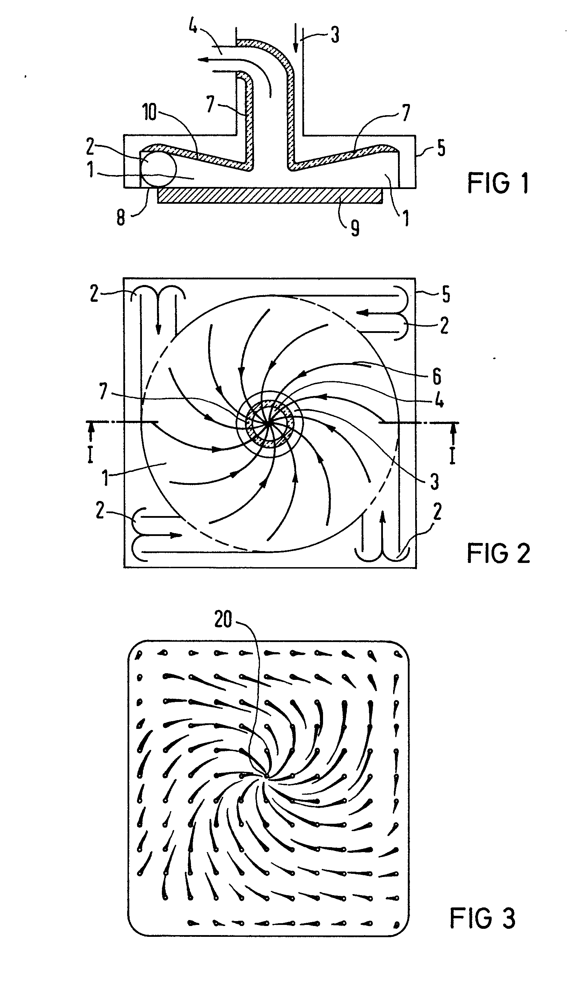

Die durch die Überlagerung einer Kreisströmung mit einer Senkenströmung entstehenden Grenzschicht-Stromlinien sind gemäß bekannten Gesetzen der Fluidmechanik Spiralen (siehe FIG 2).

Bei der Beströmung fester Wände bilden sich bekanntlich reibungsbehaftete Strömungsgrenzschichten aus, in welchen die Strömungsgeschwindigkeit der Kernströmung bis zur unmittelbaren Wandhaftung des Fluids auf Null abfällt. In dieser Strömungsgrenzschicht fällt bei Wärmeübertragung zwischen fester Wand und Fluid auch der gesamte konvektive Wärmeübergangswiderstand ab. Dicke Strömungsgrenzschichten stellen daher einen großen, dünne Grenzschichten einen kleinen konvektiven Wärmeübergangswiderstand dar. Dicke Strömungsgrenzschichten bilden sich bei schwacher Konvektion, also niedriger Strömungsgeschwindigkeit, dünne Grenzschichten bei hoher aus. Bei waagerechter Anströmung einer Wand nimmt in Strömungsrichtung bei gleichbleibender Strömungsgeschwindigkeit sowohl die Grenzschichtdicke als auch der konvektive Wärmeübergangswiderstand kontinuierlich zu.

Die vorliegende Erfindung betrifft auch eine Vorrichtung zur Durchführung des erfindungsgemäßen Verfahrens, mit deren Hilfe an Oberflächen von Bauteilen ein Wärmetausch erfolgt. Die Vorrichtung ist gekennzeichnet durch eine Strömungskammer 1, deren Grundplatte 8 die wärmetauschende Fläche eines zu kühlenden Bauteils 9 ist.

Für die Durchführung des Verfahrens ist es erforderlich, die erfindungsgemäße Vorrichtung an der wärmetauschenden Fläche zu befestigen.

Der zentrale Auslauf 4 und der Kammerdeckel 10 können eine Wärmeisolierschicht 7 aufweisen.

In einem Wirbelsenken-Strömungsapparat SIVERTEX gemäß der Erfindung wird wegen der zum Wirbelzentrum hin zunehmenden Strömungsgeschwindigkeit die Zunahme der Grenzschichtdicke und damit die Zunahme des Wärmeübergangswiderstandes kompensiert. Der Wärmeübergang bleibt somit über die gesamte Wärmetauscheroberfläche etwa konstant.

0075175

Man kann durch Veränderung des Strömungsquerschnittes in der Strömungskammer 1, insbesondere durch Formänderung dessen Kammerdeckels 10 beliebige andere, sich mit der Ortskoordinate stetig ändernde örtliche Wärmeübergangswiderstände einstellen. Kegelförmige Kammerdeckel erhöhen die Strömungsgeschwindigkeit vom Einlauf bis zum Auslauf im Wirbelsenkenströmungsapparat, trichterförmige Kammerdeckel verringern die Geschwindigkeit zum Auslauf hin. Der Wirbelsenken-Strömungsapparat kann also speziellen Wärmetauschproblemen angepaßt werden.

Gemäß einer günstigen Ausführungsform hat die erfindungsgemäße Vorrichtung mindestens einen tangential verlaufenden Leitapparat 2.

In FIG 3 ist der stationäre Grenzschicht-Stromlinienverlauf dargestellt, wie er bei der Aufzeichnung mit Hilfe des Naßfilm-Diffusionsverfahrens erhalten wurde. Längs dieser spiralförmigen Stromlinien nimmt die örtliche Strömungsgeschwindigkeit bis hin zum starr rotierenden Wirbelkern 20 kontinuierlich zu.

Geeignete Kühlmittel sind gasförmige und flüssige Fluide, insbesondere Wasser, Fluorcarbone u.a. Das erfindungsgemäße Verfahren bzw. die erfindungsgemäße Vorrichtung eignen sich für einen Wärmetausch an festen Oberflächen. Sie finden mit besonderem Vorteil zur Kühlung elektrischer und elektronischer Bauteile, vornehmlich von Flachbaugruppen, Verwendung.

Ein Ausführungsbeispiel der Erfindung ist in der Zeichnung dargestellt. Es wird im folgenden näher erläutert.

0075175

FIG 1 zeigt im Längsschnitt eine Vorrichtung für die Durchführung des erfindungsgemäßen Wärmetauschverfahrens.

FIG 2 zeigt einen Querschnitt bei I-I.

In FIG 1 ist im runden Gehäuse der Strömungskammer 1 ein Strömungsleitapparat 2 angeordnet. Ein Rohr 3 ist ein zentraler Einlauf und dazu konzentrisch sitzt der Auslauf 4 in der Mitte. Die Strömungskammer 1 ist umschlossen von dem Fluidverteilungsgehäuse 5. Mit 7 ist die Wärmeisolierung bezeichnet. Das zu kühlende Bauteil 9 hat mit der Grundplatte 8 eine gemeinsame Berührungsfläche, die Wärmedurchtrittsfläche.

Durch den Strömungsleitapparat 2 wird die Kühlflüssigkeit beispielsweise Luft, Wasser, Fluorcarbone usw. tangential in die Strömungskammer 1 eingeleitet. Es entstehen die in FIG 2 abgebildeten spiralförmigen Grenzschicht-Stromlinien 6 auf der Wärmedurchtrittsfläche in der Strömungskammer. Längs dieser Grenzschichtstromlinien nimmt die Strömungsgeschwindigkeit zum zentralen Auslauf 4 hin kontinuierlich zu und wird senkrecht zur Strömungsebene durch den zentralen Auslauf abgeleitet.

Die Strömungskammer kann kreis- oder beliebigen polygonförmigen Querschnitt aufweisen. Die Seitenwände können zylinderförmig sein oder strömungsgünstige halbtorusförmige Wände haben. Der Boden der Strömungskammer ist gleichzeitig die Wärmedurchtrittsfläche. Diese kann mit aktiven oder passiven Wirbel-Einbauten, wie Stifte, Bleche, Stolperdrähte oder Rippen zur Erhöhung der Turbulenz - insbesondere jener der Grenzschicht - versehen sein. Zu bevorzugen sind Wirbeleinbauten, welche

0075175

die Turbulenz allein in der Strömungsgrenzschicht bewirken. Dadurch wird der Wärmeübergang wesentlich verbessert. Der Druckverlust bleibt aber klein.

Der Strömungsleitapparat 2 dient zur tangentialen Einströmung des Fluids in die Strömungskammer, um den Potentialwirbel anzufachen. Der Strömungsleitapparat 2 kann 1 bis n Einläufe aufweisen. Die Achsen der Einläufe können waagrecht zur Wärmedurchtrittsfläche der Strömungskammer oder in einem Winkel vornehmlich bis 40° zur wärmetauschenden Fläche geneigt sein.

Die Einläufe in die Strömungskammer können auch düsenförmig ausgebildet sein, um durch die Strahlwirkung des Fluids die Turbulenzerzeugung in der Grenzschicht der Wärmedurchtrittsfläche zu begünstigen.

Der Strömungsleitapparat kann auch schlitzförmig vornehmlich aus senkrecht zur Wirbelebene stehenden, auch düsenförmigen Schlitzen aufgebaut sein, sofern die Schlitze das Fluid zu tangentialer Einströmung in die Strömungskammer veranlassen.

Einlauf des Strömungsleitapparates 2 und Auslauf 4 der Strömungskammer 1 sind so bemessen, daß der Druckabfall des Fluids in der Strömungskammer 1 stattfindet.

Das Fluid-Verteilergehäuse 5 hat die Aufgabe, das Fluid auf alle Einläufe des Strömungsapparates 2 gleichmäßig zu verteilen. Er besteht aus einer Kammer 5 mit einem zentralen Einlauf 3 von außen her. Der Fluidverteiler ist mit dem Strömungsleitapparat 2 mit 1 bis n Einläufen fluiddicht verbunden. Das Fluidverteilergehäuse 5 ist gegen Wärmeübertragung aus der Strömungskammer 1 isoliert.

Wenn der Strömungsleitapparat nur aus einem Einlauf in
die Strömungskammer besteht, so entfällt das Fluidverteilergehäuse.

13 Patentansprüche
 3 Figuren

0075175

VPA 81 P 7571 E

Patentansprüche

1. Verfahren zum Wärmetausch an festen Oberflächen, d a durch gekennzeichnet , daß in einer Strömungskammer an einer Oberfläche einer wärmeleitenden festen Wand mit Hilfe eines Leitapparates einer Kreisströmung eines Fluids eine Senkenströmung überlagert wird unter Bildung einer sogenannten Wirbelsenkenströmung.

2. Verfahren nach Anspruch 1, d a d u r c h g e kennzeichnet , daß die stationäre Wirbelsenkenströmung durch tangentiale Zuleitung des Fluids erzeugt und aufrechterhalten wird.

3. Verfahren nach Anspruch 1 und 2, d a d u r c h gekennzeichnet , daß das Fluid durch mindestens einen Einlauf als Leitapparat zugeführt wird.

4. Verfahren nach Anspruch 1 und 2, d a d u r c h gekennzeichnet , daß das Fluid durch mehrere Einläufe des Leitapparates über ein Fluidverteilergehäuse zugeführt wird.

5. Verfahren nach Anspruch 4, d a d u r c h g e kennzeichnet , daß bei mehreren Einläufen des Leitapparates ein Fluidverteilergehäuse mit einem gemeinsamen Zulauf verwendet wird.

6. Verfahren nach Anspruch 1, d a d u r c h g e kennzeichnet , daß die Wirbelsenkenströmung in einer Strömungskammer mit kreis- oder polygonförmigem Querschnitt erzeugt wird.

0075175

7. Verfahren nach Anspruch 6, d a d u r c h   g e -
k e n n z e i c h n e t , daß das Fluid aus der Strömungskammer senkrecht zur Strömungsebene im Zentrum des
Wirbels durch einen wärmeisolierten zentralen Auslauf
abgeleitet wird.

8. Vorrichtung zur Durchführung des Verfahrens nach
Anspruch 1 , g e k e n n z e i c h n e t   durch eine
Strömungskammer (1), deren Grundplatte (8) die wärmetauschende Fläche (9) bildet.

9. Vorrichtung zur Durchführung des Verfahrens nach den
Ansprüchen 6 und 7, d a d u r c h   g e k e n n -
z e i c h n e t , daß der Kammerdeckel (10) eben ist.

10. Vorrichtung zur Durchführung des Verfahrens nach den
Ansprüchen 6 und 7, d a d u r c h   g e k e n n -
z e i c h n e t , daß der Kammerdeckel kegelförmig ist.

11. Vorrichtung nach den Ansprüchen 6 und 7, d a d u r c h
g e k e n n z e i c h n e t , daß der Kammerdeckel
trichterförmig ist.

12. Vorrichtung nach den Ansprüchen 8 bis 11, d a -
d u r c h   g e k e n n z e i c h n e t , daß der zentrale Auslauf (4) und der Kammerdeckel (10) Wärmeisolierschichten (8) aufweisen.

13. Anwendung des Verfahrens nach den Ansprüchen 1 bis 7
zum Wärmetausch, insbesondere zur Kühlung von elektrischen
und elektronischen Bauteilen.

FIG 1

FIG 2

FIG 3